# EUROPEAN PATENT SPECIFICATION

(11) **EP 4 350 755 B1**
(45) Date of publication and mention of the grant of the patent: **29.07.2026**
(21) Application number: 22923339.0
(22) Date of filing: 17.10.2022
(51) Int. Cl.: H10W 76/153, H10W 76/60, H10W 76/12, H10W 76/15

(54) **POWER MODULE WITH A COVER PLATE AND GASKET**
LEISTUNGSMODUL MIT EINER ABDECKPLATTE UND EINER DICHTUNG
MODULE D'ALIMENTATION AVEC PLAQUE DE RECOUVREMENT ET JOINT

(30) Priority: 29.01.2022 CN 202210112651
(43) Date of publication of application: 10.04.2024
(73) Proprietor: Huawei Digital Power Technologies Co., Ltd., Shenzhen, Guangdong 518043 (CN)
(72) Inventor: ZHANG, Haiwen, Shenzhen, Guangdong 518043 (CN); LIU, Zhiling, Shenzhen, Guangdong 518043 (CN); WANG, Yanbo, Shenzhen, Guangdong 518043 (CN)
(74) Representative: Maiwald GmbH
(86) International application number: PCT/CN2022/125733
(87) International publication number: WO 2023/142539

(56) References cited:
- EP-A2- 2 608 254
- WO-A1-00/42656
- CN-A- 103 178 022
- CN-A- 103 730 426
- CN-A- 107 799 428
- CN-A- 108 682 634
- CN-A- 113 206 051
- CN-A- 114 582 810
- CN-U- 211 017 053
- JP-A- 2017 126 682
- US-A- 5 038 197
- US-A1- 2014 199 861
- US-A1- 2016 218 454

## Description

### TECHNICAL FIELD

This application relates to the field of encapsulation technologies, and in particular, to a cover plate, a power module, and an electronic device.

### BACKGROUND

A power module is a functional module formed after power electronic devices are combined based on a specific function and then encapsulated, and may be widely used in fields such as a servo motor, a frequency converter, or an inverter. During specific application, to facilitate connection between the power module and a system end, a pin (pin) may be generally led out from the top of the power module, so as to implement quick crimping or welding between the system end and the pin of the power module.

At present, during encapsulation of an existing power module, a substrate (for example, a copper-clad ceramic substrate), a chip, and a pin are usually assembled and welded, and then each component is protected through performing plastic packaging by using a plastic packaging material. However, in an injection molding process of the plastic packaging material, the plastic packaging material further needs to be pressed by using a mold. In this process, the plastic packaging material blocks an upper mold cavity. Consequently, the pin is prone to being skewed, and a position degree of the pin cannot be ensured. Therefore, a degree of adaptation between the power module and the system end is reduced. CN 103 178 022 A discloses a power semiconductor module including an electronic circuit and a housing with a housing cover. US 5 038 197 A describes a hermetically sealed die package with floating source. US 2014/0199861 A1 discloses an electrical press-fit pin for a semiconductor device.

Based on this, how to implement effective limiting on the pin of the power module has become a difficult problem to be urgently resolved by a person skilled in the art.

### SUMMARY

This application provides a cover plate, a power module, and an electronic device, to improve a position degree of a pin of the power module, and improve a product yield rate of the power module.

According to a first aspect, this application provides a power module comprising a pin and a cover plate according to claim 1.

In a possible implementation of this application, a material of a base material of the plate body may be at least one of polyphenylene sulfide, polyphthalamide, and polypropylene. In this way, structural strength of the plate body can be effectively improved, and the pin can be reliably supported, thereby ensuring position precision of the pin.

In a possible implementation of this application, the gasket may further include a limiting part, and the limiting part is disposed on a surface that is of the body part and that faces the plate body. Each limiting part is inserted into one first hole in a one-to-one correspondence, and the limiting part is attached to a hole wall of the corresponding first hole, to improve reliability of combination between each limiting part and the corresponding first hole. In addition, the limiting part has a third hole, and in the direction from the first face to the second face, the third hole penetrates through the limiting part. In this way, each pin may be inserted into one third hole in a one-to-one correspondence after passing through one second hole, and each pin may be in interference fit with the corresponding third hole. Therefore, while protecting the pin, the limiting part further can effectively improve the position precision of the pin.

In a possible implementation of this application, a length of the limiting part inserted into the first hole may be less than or equal to a hole depth of the first hole. In this way, impact of the limiting part on an effective length of the pin exposed on the cover plate may be avoided, thereby helping improve reliability of connection between a system end and the pin of the power module.

In addition, a wall thickness of the limiting part may be greater than or equal to 0.1 mm and less than or equal to 5 mm, to ensure the position precision of the pin while effectively protecting the pin.

To enable the limiting part to closely cooperate with the first hole, in a possible implementation of this application, the limiting part may include a connection part and an extension part. The connection part may be fixedly connected to the body part, and the extension part may extend from the connection part in a direction away from the body part. In addition, the extension part may include a first surface and a second surface that are disposed back from each other; and in a direction from the extension part to the connection part, the first surface tilts in a direction away from the second surface, and/or the second surface tilts in a direction away from the first surface. The first surface and the second surface are separately tilted in the direction away from each other, to conveniently insert the limiting part into the first hole. In addition, this may help increase a surface area of the limiting part, thereby helping increase a contact area between the limiting part and the first hole, and effectively improving reliability of attaching between the limiting part and the first hole. During specific implementation, an angle at which the first surface tilts in the direction away from the second surface may be greater than or equal to 0° and less than or equal to 60°; and/or an angle at which the second surface tilts in the direction away from the first surface may be greater than or equal to 0° and less than or equal to 60°.

In a possible implementation of this application, a first step surface is further provided between the connection part and the extension part. In this case, the first hole may be set as a step hole, and the step hole has a second step surface such that when the limiting part is inserted into the first hole, the first step surface abuts onto the second step surface. In this way, the length of the limiting part inserted into the first hole may be adjusted. In addition, the contact surface between the limiting part and the first hole can be effectively increased. This helps improve reliability of attaching between the limiting part and the first hole.

In a possible implementation of this application, when the third hole is disposed, in a direction from the connection part to the extension part, a section shape of the third hole may be a T shape. In this way, a partial structure of the pin that is close to the connection part can be avoided, and a partial structure of the pin that is located in the extension part can also be used to implement interference fit with the third hole, thereby avoiding damage to the pin and improving limiting precision of the limiting part on the pin. In another possible implementation of this application, the section shape of the third hole may be further an I shape, to simplify a processing technic of the third hole.

In addition, in the direction from the connection part to the extension part, the third hole may include a first sub-hole and a second sub-hole. The second sub-hole may be a rectangular hole, and in an aperture direction of the second sub-hole, a length of a section of the rectangular hole may be greater than or equal to 0.1 mm and less than or equal to 2 mm. And/or a width of the section of the rectangular hole is greater than or equal to 0.1 mm and less than or equal to 2 mm. In this way, the pin can be conveniently inserted into the second sub-hole while interference fit between the pin the second sub-hole can be implemented, thereby facilitating assembly of the pin and the cover plate.

In this application, to enable the gasket to play a buffer role between the plate body of the cover plate and another structure of the power module, a height of the gasket body higher than the second face may be greater than or equal to 0.1 mm and less than or equal to 10 mm.

In addition, the second face of the plate body is provided with a baffle wall, the baffle wall is of a ring structure, the body part is disposed in a closed region enclosed by the baffle wall, and a height of the baffle wall higher than the second face is greater than or equal to a height of the body part higher than the second face. In this way, in a process of extrusion molding performed on the body part, overflow of a material of the gasket to surroundings may be avoided.

It can be learned from the foregoing description of the gasket that the body part of the gasket may play a buffer role, and the limiting part may play a protection role for the pin. Based on this, in this application, the material of the gasket may be selected as at least one of vulcanized silicone, vulcanized silicone rubber, polydimethylsiloxane, and polyvinyl chloride.

In addition, in this application, the gasket may alternatively be an integrally formed structure. In this way, structural reliability of the gasket can be effectively improved, thereby improving structural stability of the cover plate.

According to a second aspect, this application further provides a power module. The power module includes a pin and the cover plate in the first aspect. According to the power module provided in this application, each pin is inserted into one first hole of the cover plate in a one-to-one correspondence, and the pin is in interference fit with the first hole. Therefore, position precision of the pin of the power module is high, thereby effectively improving a product yield rate of the power module, and improving reliability of connection between the power module and a system end.

In addition to the foregoing structure, the power module may further include a substrate and a chip, the pin and the chip may be disposed on a same surface of the substrate, and both the pin and the chip are electrically connected to the substrate. In addition, the substrate is provided with a plastic packaging material, and the plastic packaging material covers the chip. **In** addition, because the gasket is disposed on the plate body of the cover plate of the power module. When the plastic packaging material is pressed by using the cover plate, the body part of the gasket may abut onto the plastic packaging material, so that the body part may also play a buffer role between the plate body and the chip while implementing performing plastic packaging on the chip. **In** this way, an acting force exerted by the plate body on the chip can be reduced, to reduce a risk of damage to the chip. **In** this way, a plurality of chips may be disposed on the substrate, so that power density of the entire power module can be effectively increased, and a parasitic parameter can be helped to reduce.

According to a third aspect, this application further provides an electronic device. The electronic device may include an accommodating cavity and the power module according to the second aspect. The power module may be accommodated in the accommodating cavity. **In** the electronic device, because a position degree of a pin of the power module is high, power density of the power module can be effectively improved, and a parasitic parameter can be effectively reduced, performance of the electronic device can be improved.

### BRIEF DESCRIPTION OF DRAWINGS

FIG. 1 is a schematic diagram of a structure of a mold according to an embodiment of this application;
FIG. 2 is a schematic diagram of a correspondence between a pin and a hollowed-out zone of a mold according to an embodiment of this application;
FIG. 3 is a schematic diagram of a structure of a cover plate according to an embodiment of this application;
FIG. 4 is a side view of a cover plate according to an embodiment of this application;
FIG. 5 is a schematic diagram of a structure of a second face side of a cover plate according to an embodiment of this application;
FIG. 6 is a schematic diagram of a structure of a gasket according to an embodiment of this application;
FIG. 7 is a schematic diagram of a structure of a cover plate according to another embodiment of this application;
FIG. 8 is a schematic diagram of a structure of a first face side of a cover plate according to another embodiment of this application;
FIG. 9 is an enlarged view of a local structure of a position A in FIG. 8;
FIG. 10 is a schematic diagram of a structure of a limiting part according to an embodiment of this application;
FIG. 11 is a sectional view of a limiting part according to an embodiment of this application;
FIG. 12 is a sectional view of a limiting part according to another embodiment of this application;
FIG. 13 is a schematic diagram of a structure of a second face side of a cover plate according to another embodiment of this application;
FIG. 14 is an exploded view of a power module according to an embodiment of this application; and
FIG. 15 is a schematic diagram of an assembly structure of a power module according to an embodiment of this application.

### Reference numerals:

1: mold; 101: main body; 102: hollowed-out zone; 2: pin;
3: cover plate; 301: plate body; 3011: first face; 3012: second face; 3013: first hole; 3014: baffle wall; 302: gasket;
3021: body part; 30211: second hole; 3022: limiting part; 30221: third hole; 302211: first sub-hole;
302212: second sub-hole; 30222: connection part; 30223: extension part; 302233: first surface; 302234: second surface;
3023: first step surface; 4: substrate; 5: chip; 6: molding compound; 601: mounting groove.

### DESCRIPTION OF EMBODIMENTS

Terms used in the following embodiments are merely intended to describe particular embodiments, but are not intended to limit this application. As used in this specification and the appended claims of this application, singular expressions "one", "a", "the", "the foregoing", "this", and "the one" are also intended to include expressions such as "one or more", unless otherwise specified in the context clearly.

Reference to "an embodiment", "some embodiments", or the like described in this specification indicates that one or more embodiments of this application include a specific feature, structure, or characteristic described with reference to the embodiments. Terms "include", "contain", "have", and their variants all mean "include but are not limited to", unless otherwise emphasized.

For ease of understanding a cover plate, a power module, and an electronic device provided in embodiments of this application, the following first describes an application scenario of the cover plate. The power module is a module formed through combining and potting by a power electronic device based on a specific function, and may be applied to, but is not limited to, an electronic device like a servo motor, a frequency converter, or an inverter.

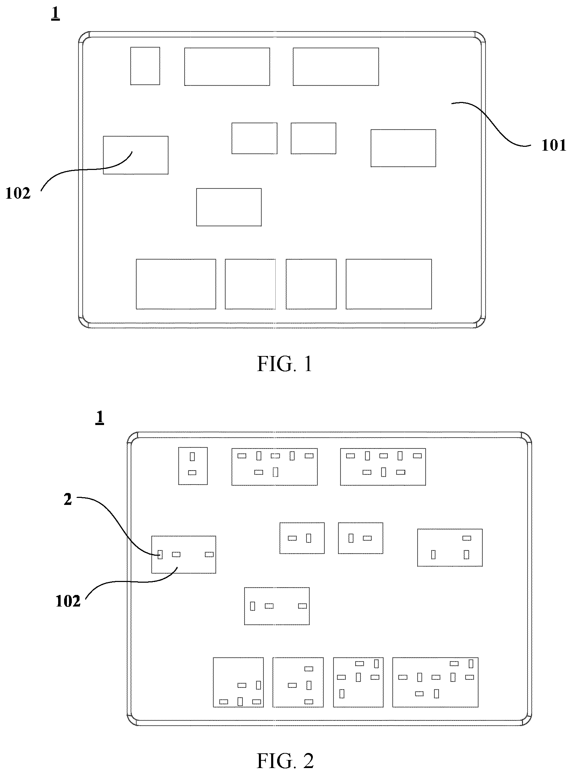

The power module is generally provided with a pin, and the pin extends to the outside of the power module. In this way, connection between a system end of the electronic device and the pin may be conveniently implemented. In addition, the power module may further include a substrate and a chip. The chip and the pin may be fixed on the substrate through welding, bonding, or the like. At present, during assembly of the existing power module, after assembly of the substrate, the chip, and the pin is completed, in order to protect components such as the chip and the pin on the substrate, a plastic packaging material further needs to be injected, so as to implement encapsulation protection for the components on the substrate. Generally, in order to improve reliability of combining the plastic packaging material with the substrate and the components on the substrate, the plastic packaging material is pressed by using a mold 1 shown in FIG. 1.

When the mold 1 is disposed, the mold 1 may include a main body 101 and a hollowed-out zone 102 disposed on the main body 101. At present, to improve universality of the mold 1, an opening area of the hollowed-out zone 102 of the mold 1 is generally large, so that a design of the mold 1 for different power modules may be avoided, thereby saving costs. When the mold 1 is used to press the plastic packaging material, a pin 2 may be located in the corresponding hollowed-out zone 102. Refer to FIG. 2. FIG. 2 shows a correspondence between the pin 2 and the hollowed-out zone 102 of the mold 1 according to a possible embodiment of this application. It can be seen from FIG. 2 that, in a pressing process, a plurality of pins 2 may be located in the same hollowed-out zone 102. Because the plastic packaging material has specific flowability, when being squeezed, the plastic packaging material flows in a direction of the hollowed-out zone 102. In addition, structural stability of the pin 2 is poor, and silicon gel is likely to cause the pin 2 to tilt in a flow process. In addition, when a large amount of silicon gel is squeezed into the hollowed-out zone 102, the hollowed-out zone 102 is blocked to cause overflow of the plastic packaging material. However, overflow of the plastic packaging material wraps the pin 2 located in the hollowed-out zone 102. This may affect connection between the pin 2 and the system end, thereby affecting implementation of a function of an electronic device to which the power module is applied.

It may be understood that, in the existing power module at present, the plastic packaging material directly covers the chip. To avoid damage to the chip in a process in which the mold 1 presses the plastic packaging material, the mold 1 needs to avoid the chip. In this way, the chip can be disposed only in the hollowed-out zone 102 corresponding to the mold 1. Therefore, a quantity of chips that can be disposed on the substrate is limited, and space for improving power density of the power module is limited.

The cover plate provided in this application is intended to resolve the foregoing problem, so as to implement a pin limiting design by disposing holes that are in a one-to-one correspondence with pins of the power module on the cover plate, and enable the pins to perform interference fit with the corresponding holes, thereby improving a position degree of the pins, and improving a product yield rate of the power module. In this way, reliability of connection between the power module and the system end can be improved, thereby improving performance of the electronic device. To make the objectives, technical solutions, and advantages of this application clearer, the following further describes this application in detail with reference to the accompanying drawings.

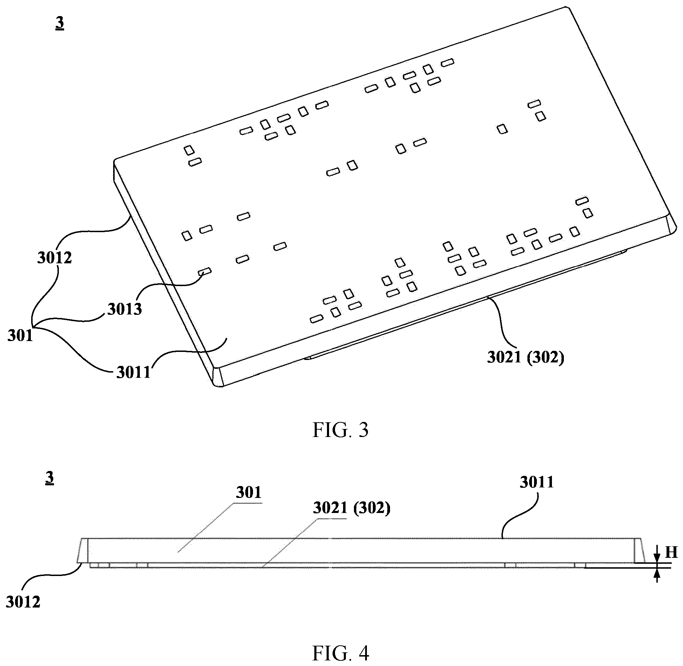

Refer to FIG. 3. FIG. 3 is a schematic diagram of a structure of a cover plate 3 according to a possible embodiment of this application. In this application, the cover plate 3 includes a plate body 301, and the plate body 301 includes a first face 3011 and a second face 3012 that are disposed back from each other. The first face 3011 may be used as an appearance face of the plate body 301.

The plate body 301 is provided with a first hole 3013. In this application, a section shape of the first hole 3013 is not limited. For example, the first hole 3013 may be in a regular shape such as a circle, an ellipse, or a rectangle, or may be in another possible irregular shape. In addition, in a direction from the first face 3011 to the second face 3012, the first hole 3013 penetrates through the plate body 301. In this application, a quantity of first holes 3013 on the plate body 301 is not limited. For example, there may be one or more first holes 3013, for example, two, three, five, or ten. The quantity may be set based on a quantity of pins of a power module to which the cover plate 3 is applied, so that each pin can be inserted into one first hole 3013 in a one-to-one correspondence, and each pin is in interference fit with the first hole 3013 corresponding to the pin. In this way, a position degree of each pin can be effectively improved, and a product yield rate of the power module can be improved. It should be noted that the interference fit between the pin and the first hole 3013 described in this application may guide the pin to directly contact a hole wall of the first hole 3013 to implement interference fit between the pin and the first hole 3013, or may guide the pin to indirectly contact the hole wall of the first hole 3013 to implement interference fit between the pin and the first hole 3013.

In addition, when the plate body 301 is provided with a plurality of first holes 3013, the plurality of first holes 3013 may be arranged in an array, or the plurality first holes 3013 may be arranged in any possible manner. This may be arranged in an arrangement manner of the pins in the power module.

In this application, a material of a base material of the plate body 301 may be selected as at least one of high-strength and plastic materials such as polyphenylene sulfide (PPS), polyphthalamide (PPA), and polypropylene (PP). In this way, the material of the base material of the plate body 301 is selected, so that the base material has high strength, and the base material can effectively support the pin inserted into the first hole 3013 of the plate body 301, thereby improving the position degree of the pin. In addition, to increase strength of the plate body 301, glass fibers or other possible inorganic additives may be added to the base material of the plate body 301.

In addition, a specific shape of the plate body 301 is not limited in this application. For example, the plate body may be a regular shape such as a rectangle, a circle, or a rhombus, or may be another possible irregular shape. The plate body may be properly designed based on another structure of the power module to which the cover plate 3 is applied.

Still refer to FIG. 3. In this application, the cover plate includes a gasket 302. The gasket 302 includes a body part 3021. The body part 3021 is disposed on the second face 3012 of the plate body 301, and the body part 3021 is connected to the second face 3012 of the plate body 301. A connection manner thereof may be but is not limited to bonding. A material of the body part 3021 may be but is not limited to at least one of vulcanized silicone, vulcanized silicone rubber, polydimethylsiloxane (PDMS), and polyvinyl chloride (PVC). By disposing the gasket 302 on the second face 3012 of the plate body 301, when the cover plate 3 is assembled with another structure of the power module, direct contact between the plate body 301 and a component like a chip of the power module may be avoided, thereby avoiding damage to the component like the chip.

Refer to FIG. 4. FIG. 4 is a side view of the cover plate 3 according to this embodiment of this application. It can be seen from FIG. 4 that, the body part 3021 of the gasket 302 may be higher than the second face 3012 of the plate body 301 by a specific height H. For example, the height H may be greater than or equal to 0.1 mm and less than or equal to 10 mm. By setting a distance that the body part 3021 is higher than the second face 3012 of the plate body 301 to be within the foregoing range, the body part 3021 may play an effective buffer role between the cover plate 3 and the component like the chip, thereby effectively reducing a risk of damage to the chip by the plate body 301. In addition, a position degree of assembling the cover plate 3 and another structure of the power module may be further ensured.

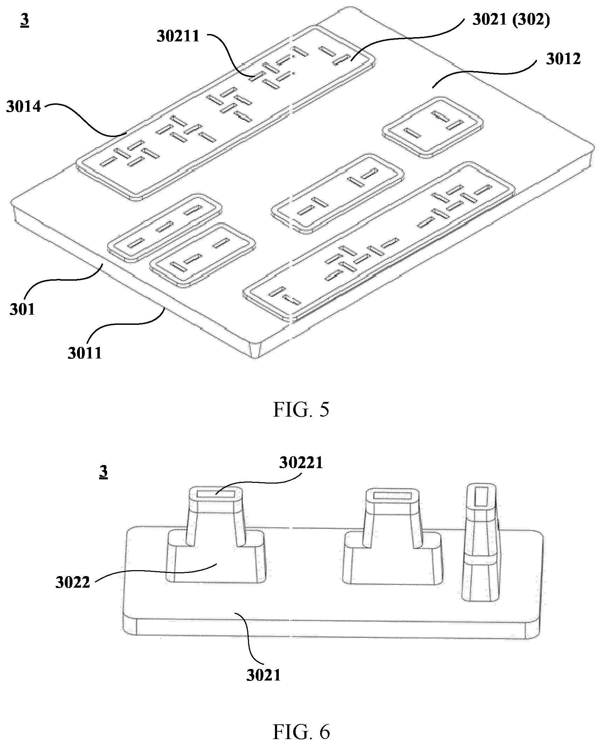

In this application, in the direction from the first face 3011 to the second face 3012, a projection of a section of the first hole 3013 of the plate body 301 shown in FIG. 3 in a radial direction of the first hole on a plane on which the body part 3021 is located may fall within a contour range of the body part 3021. In addition, refer to FIG. 5. FIG. 5 shows a structure of a side of the second face 3012 of the cover plate 3. It should be noted that, the plate body 301 is provided with a gasket 302, to simplify a structure of the gasket 302. Alternatively, as shown in FIG. 5, the plate body 301 may be provided with a plurality of gaskets 302, and corresponding to each gasket 302, the plate body 301 is provided with at least one first hole 3013. In this way, a material of the gasket 302 may be reduced, so that costs of the cover plate 3 are effectively reduced.

Still refer to FIG. 5. The body part 3021 of the gasket 302 is provided with a second hole 30211. In the direction from the first face 3011 to the second face 3012, the second hole 30211 penetrates through the body part 3021. In addition, in this application, a quantity of second holes 30211 may be greater than or equal to the quantity of first holes 3013, provided that each first hole 3013 can be disposed in correspondence with one second hole 30211. For example, the quantity of second holes 30211 may be the same as the quantity of first holes 3013, and the first holes 3013 and the second holes 30211 is disposed in a one-to-one correspondence.

In this application, a section shape of the second hole 30211 is not limited. For example, the section shape of the second hole may be a regular shape such as a circle, an ellipse, or a rectangle, or may be another possible irregular shape, provided that the pin of the power module can be inserted into the first hole 3013 through the second hole 30211.

It should be noted that, in this application, the gasket 302 may be directly formed on the plate body 301. During specific implementation, still refer to FIG. 5. The second face 3012 of the plate body 301 may be processed first. A processing manner may include but is not limited to spraying or coating adhesives on the second face 3012 of the plate body 301, and then heating the plate body 301 to volatilize substances such as moisture in the adhesives. It may be understood that, a region in which the plate body 301 is processed may be at least a region in which the gasket 302 needs to be disposed on the plate body 301, so that reliability of combining a subsequently formed gasket 302 with the plate body 301 is improved.

Then, the material for forming the gasket 302 mentioned above may be coated on the processed region of the second face 3012 of the plate body 301, and the material is processed by using at least one processing technic of extrusion, hot pressing, or hot forming, to form the gasket 302 closely combined with the plate body 301.

Finally, corresponding to each first hole 3013 shown in FIG. 3, a second hole 30211 is formed on the body part 3021, and in the direction from the first face 3011 to the second face 3012, the second hole 30211 penetrates through the body part 3021, so that the first hole 3013 is connected to the second hole 30211.

It may be understood that, in a process of forming the gasket 302 on the plate body 301, when extrusion, hot pressing, or hot forming is performed on the material of the gasket 302, the material for forming the gasket 302 has a problem of overflowing to surroundings. To solve this problem, continue to refer to FIG. 5. The second face 3012 of the plate body 301 is provided with a baffle wall 3014. The baffle wall 3014 and the plate body 301 may be an integrally formed structure, or the baffle wall 3014 and the plate body 301 are separately disposed structures, and are fixedly connected through bonding or the like. In this application, materials of the baffle wall 3014 and the plate body 301 may be the same or may be different. In addition, the baffle wall 3014 is of a closed ring structure. In this application, the ring structure is a circular ring structure, or a rectangular ring structure with a rounded corner shown in FIG. 5, or another closed ring structure of a regular shape or an irregular shape. The body part 3021 is located in a closed region enclosed by the baffle wall 3014, and a height of the baffle wall 3014 higher than the second face 3012 is greater than or equal to a height of the body part 3021 of the gasket 302 higher than the second face 3012. In this way, overflow of the material of the gasket 302 can be effectively avoided.

It should be noted that, when there is one gasket 302, one baffle wall 3014 is disposed. In this case, projections of sections of the first holes 3013 in the radial direction of the first holes on the plane where the gasket 302 is located are all located in a closed region enclosed by the baffle wall 3014. In addition, when there are a plurality of gaskets 302, a baffle wall 3014 may be disposed for each gasket 302, so that a projection of a section of the first hole 3013 disposed for each gasket 302 in the radial direction of the first hole on the plane where the gasket 302 is located in a closed region enclosed by the same baffle wall 3014.

In this application, in addition to directly forming the gasket 302 on the plate body 301 by using the foregoing form method, in some possible embodiments of this application, the gasket 302 may alternatively be independently formed by using a specific mold. Then, the body part 3021 of the gasket 302 is fixed on the second face 3012 of the plate body 301 through bonding, and the second hole 30211 of the body part 3021 and the first hole 3013 of the plate body 301 are disposed in a one-to-one correspondence. In this embodiment, the second face 3012 of the plate body 301 is provided with the baffle wall 3014, and the baffle wall 3014 may limit a position of the body part 3021 on the second face 3012 of the plate body 301, to improve alignment precision of the second hole 30211 and the first hole 3013.

Refer to FIG. 6. FIG. 6 is a schematic diagram of a structure of the gasket 302 according to a possible embodiment of this application. In this embodiment, the gasket 302 may further be provided with a limiting part 3022. Refer to FIG. 5 and FIG. 6. The limiting part 3022 may be disposed on a surface that is of the body part 3021 and that faces the plate body 301. It should be noted that, in this embodiment of this application, the limiting part 3022 and the body part 3021 may be an integrally formed structure, to improve structural reliability of the gasket 302. In some other possible embodiments of this application, the limiting part 3022 and the body part 3021 may alternatively be separate structures that are separately formed, and then are fixedly connected through bonding or the like, so that the gasket 302 can be designed flexibly.

In addition, a material of the limiting part 3022 may also be but is not limited to at least one of vulcanized silicone, vulcanized silicone rubber, polydimethylsiloxane, and polyvinyl chloride. In addition, materials of the limiting part 3022 and the body part 3021 may be the same or may be different.

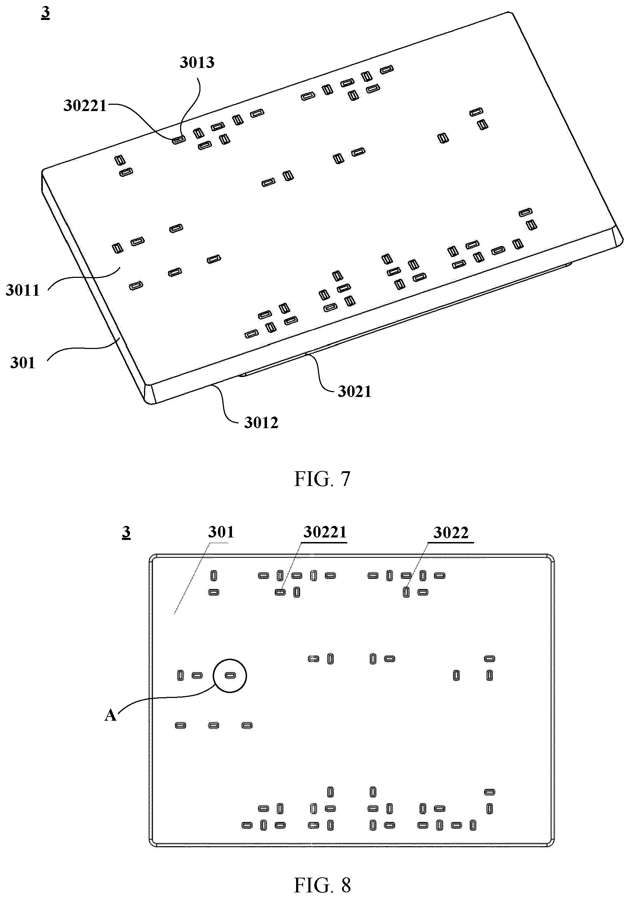

Refer to FIG. 7. FIG. 7 is a schematic diagram of a structure of the cover plate 3 according to another possible embodiment of this application. In this embodiment of this application, the limiting parts 3022 of the gasket 302 may be disposed in a one-to-one correspondence with the first holes 3013 of the body part 3021, so that each limiting part 3022 can be inserted into one first hole 3013 in a one-to-one correspondence, and the limiting part 3022 may be attached to the hole wall of the first hole 3013. In addition, it can be learned from the foregoing description of the first hole 3013 and the second hole 30211 that, when the cover plate 3 is applied to the power module, the pin needs to pass through the second hole 30211 and be inserted into the first hole 3013. Based on this, refer to both FIG. 6 and FIG. 7. The limiting part 3022 may be provided with a third hole 30221, and in the direction from the first face 3011 to the second face 3012 of the plate body 301, the third hole 30221 penetrates through the limiting part 3022, and the third hole 30221 is connected to the second hole 30211 (refer to FIG. 5).

In this way, when the cover plate 3 is applied to the power module, the pin may be inserted into the third hole 30221 through the second hole 30211, and the pin is in interference matching with the third hole 30221. It can be learned from the foregoing description of the material of the limiting part 3022 that, because the material selected for the limiting part 3022 may be a flexible material, the limiting part 3022 can protect the pin by performing interference fit between the pin and the third hole 30221 of the limiting part 3022. In addition, because structural strength of the plate body 301 of the cover plate 3 is high, the cover plate 3 can reliably support the pin, thereby effectively improving position precision of the pin.

In this application, a length of the limiting part 3022 inserted into the first hole 3013 may be less than or equal to a hole depth of the first hole 3013. For example, refer to FIG. 8. FIG. 8 is a schematic diagram of a structure of a side of the first face 3011 of the cover plate 3 shown in FIG. 7. In this embodiment of this application, an end face that is of the limiting part 3022 and that is away from the body part 3021 may be flush with the first face 3011. In this way, impact of the limiting part 3022 on an effective length of the pin exposed on the cover plate 3 may be avoided, thereby helping improve reliability of connection between a system end and the pin of the power module.

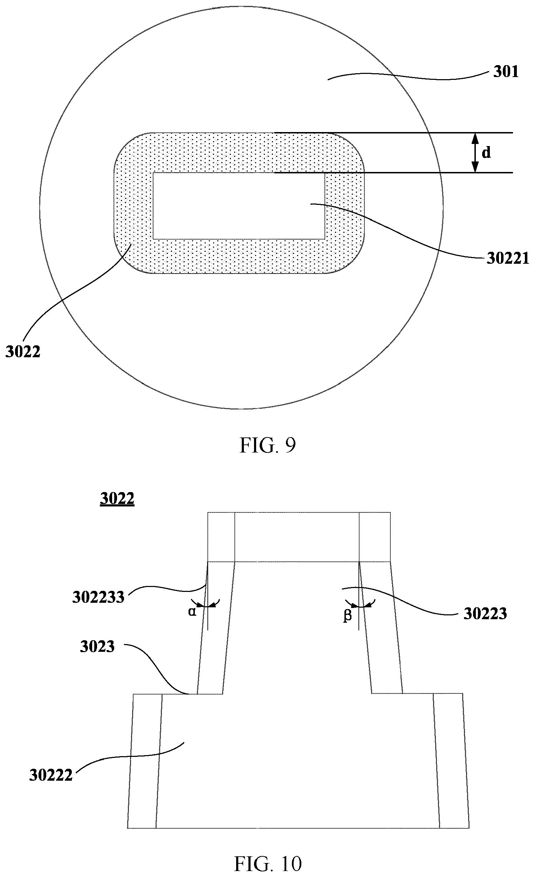

In addition, refer to FIG. 9. FIG. 9 is an enlarged view of a local structure of a position A in FIG. 8. In a possible embodiment of this application, a wall thickness d of the limiting part 3022 may be greater than or equal to 0.1 mm and less than or equal to 5 mm. For example, the wall thickness d may be 0.5 mm. This can effectively protect the pin, and ensure the position precision of the pin.

In this application, to improve tightness of combining the limiting part 3022 with the first hole 3013, an external shape of the limiting part 3022 may be properly designed, so that an external contour of the limiting part 3022 can match the hole wall of the first hole 3013. For example, refer to FIG. 10. FIG. 10 shows the external shape of the limiting part 3022 according to a possible embodiment of this application. In this embodiment of this application, the external shape of the limiting part 3022 may be disposed in a stepped shape. During specific implementation, the limiting part 3022 may include a connection part 30222 and an extension part 30223. The connection part 30222 and the extension part 30223 may be an integrally formed structure, or may be two separately disposed structures and are fixedly connected through bonding or the like.

In addition, refer to FIG. 6 and FIG. 10 together. The connection part 30222 may be fixedly connected to the body part 3021, and the extension part 30223 extends from the connection part 30222 to the direction away from the body part 3021. A projection of the extension part 30223 on the body part 3021 may fall within a contour range of a projection of the connection part 30222 on the body part 3021. Still refer to FIG. 10. The extension part 30223 may include a first surface 302233 and a second surface 302234 that are disposed back from each other, and in a direction from the extension part 30223 to the connection part 30222, the first surface 302233 tilts in a direction away from the second surface 302234, and a tilt angle α of the first surface may be greater than or equal to 0° and less than or equal to 60°. In addition, when the second surface 302234 is disposed, in the direction from the extension part 30223 to the connection part 30222, the second surface 302234 may tilt in a direction away from the first surface 302233, and a tilt angle β of the second surface may be greater than or equal to 0° and less than or equal to 60°. In this way, the limiting part 3022 may be conveniently inserted into the first hole 3013 shown in FIG. 7, and a contact area between the limiting part 3022 and the hole wall of the first hole 3013 may be effectively increased, thereby improving tightness of attaching between the limiting part 3022 and the first hole 3013.

Still refer to FIG. 6 and FIG. 10. In this application, there is a first step surface 3023 between the connection part 30222 and the extension part 30223. The first step surface 3023 may be disposed between the first surface 302233 and the connection part 30222, and/or the first step surface 3023 is disposed between the second surface 302234 and the connection part 30222.

It may be understood that, to enable the limiting part 3022 to be inserted into the first hole 3013, the external shape of the limiting part 3022 may match a shape of the first hole 3013. In this application, the first hole 3013 may be set as a step hole, and the step hole has a second step surface. In this way, when the limiting part 3022 is inserted into the first hole 3013, the first step surface 3023 may be abutted onto the second step surface, thereby adjusting the length of the limiting part 3022 inserted into the first hole 3013. In addition, because the limiting part 3022 and the first hole 3013 are designed in this way, the contact area between the limiting part and the first hole can be effectively increased, so that reliability of attaching between the limiting part and the first hole is helped to improve.

In this application, the limiting part 3022 and the first hole 3013 may be disposed in the manner in the foregoing embodiment. In addition, in some possible embodiments of this application, the limiting part 3022 and the first hole 3013 may be alternatively disposed in another possible manner. For example, an outer surface of the limiting part 3022 may be disposed as a cylindrical surface, and the first hole 3013 may be disposed as a circular hole, to simplify the structure of the cover plate 3.

It should be noted that, when the body part 3021 and the limiting part 3022 of the gasket 302 are an integrally formed structure, the gasket 302 may be directly formed on the plate body 301 by using the molding method mentioned above. When an operation such as extrusion, hot pressing, or hot forming is performed on the material of the gasket 302, the material may enter the first hole 3013 to form the limiting part 3022, and the limiting part 3022 is in interference fit with the first hole 3013.

It should be noted that, in a possible embodiment of this application, the gasket 302 and the plate body 301 may alternatively be two separately formed structures. In this way, the limiting part 3022 of the gasket 302 may be inserted into the first hole 3013 of the plate body 301, and the limiting part 3022 is attached to the hole wall of the first hole 3013. In addition, to improve a degree of combination between the limiting part 3022 and the hole wall of the first hole 3013, the limiting part 3022 may perform interference fit with the first hole 3013. Then, the body part 3021 of the gasket 302 and the second face 3012 of the plate body 301 are fixed through bonding or the like.

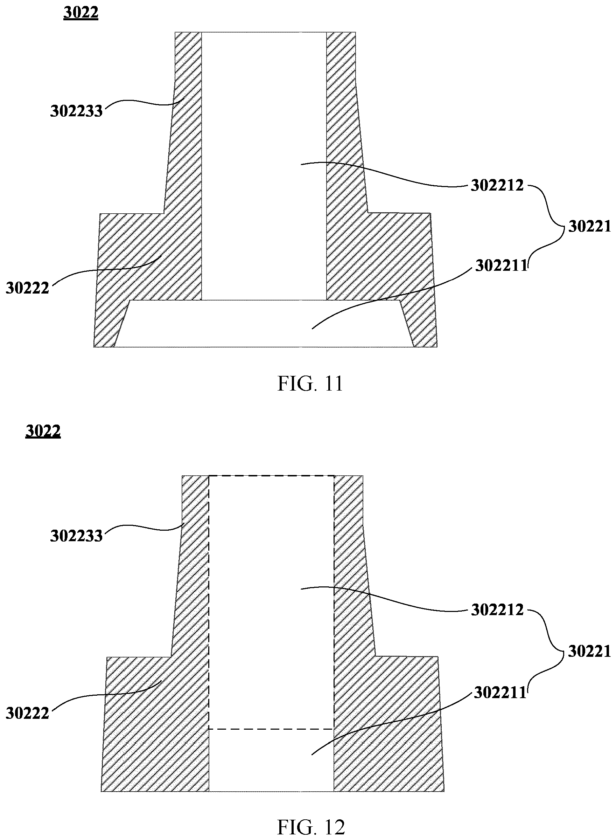

Refer to FIG. 11. FIG. 11 is a sectional view of the limiting part 3022 according to a possible embodiment of this application. FIG. 11 shows a section shape of the third hole 30221. In a direction from the connection part 30222 to the extension part 30223, the third hole 30221 may include a first sub-hole 302211 and a second sub-hole 302212 that are connected. In addition, in the direction from the connection part 30222 to the extension part 30223, a section of the third hole 30221 is disposed in a T shape. In this way, the first sub-hole 302211 of the third hole 30221 may be used as an avoidance hole for avoiding the pin, and a part of the second sub-hole 302212 that is inserted into the third hole 30221 and that is of the pin may be in interference fit with the second sub-hole 302212, thereby avoiding damage to the pin and improving limiting precision of the limiting part 3022 on the pin.

It should be noted that, in this application, section shapes of the first sub-hole 302211 and the second sub-hole 302212 in an aperture direction are not limited. The first sub-hole 302211 may be but is not limited to a regular-shaped hole like a circular hole, a rectangular hole, or a tapered hole, or may be one of some irregular holes. The second sub-hole 302212 may be but is not limited to a regular-shaped hole like a circular hole, a rectangular hole, or a tapered hole, or may be one of some irregular holes. The section shapes of the first sub-hole 302211 and the second sub-hole 302212 may be the same or may be different. In addition, when the second sub-hole 302212 is a rectangular hole, in the aperture direction of the second sub-hole, a length of a section of the second sub-hole 302212 may be greater than or equal to 0.1 mm and less than or equal to 2 mm, and/or a width of the section of the rectangular hole may be greater than or equal to 0.1 mm and less than or equal to 2 mm. For example, the length of the section of the second sub-hole 302212 may be 1.5 mm, and the width of the section may be 0.5 mm. In this way, the pin can be conveniently inserted into the second sub-hole 302212 while interference fit between the pin and the second sub-hole 302212 can be implemented, thereby facilitating assembly of the pin and the cover plate.

The foregoing embodiment is merely an example for description of a disposition manner of the third hole 30221. In another possible embodiment of this application, the third hole 30221 may alternatively be disposed in another possible manner. For example, refer to FIG. 12. FIG. 12 is a sectional view of the limiting part 3022 according to another embodiment of this application. In the embodiment shown in FIG. 12, in the direction from the connection part 30222 to the extension part 30223, the section of the third hole 30221 may be disposed in an I shape. In addition, in the aperture direction, the section shape of the first sub-hole 302211 may be the same as the section shape of the second sub-hole 302212, to simply a processing technic of the third hole 30221. In some possible embodiments of this application, in the aperture direction, the section shape of the first sub-hole 302211 may be different from the section shape of the second sub-hole 302212, to flexibly dispose the third hole 30221.

It may be understood that in this application, when the body part 3021 and the limiting part 3022 of the gasket 302 are an integrally formed structure, the second hole 30211 and the third hole 30221 may also be integrally formed holes, that is, the second hole 30211 and the third hole 30221 may be processed in a same process, to effectively simplify a preparation technic of the gasket 302.

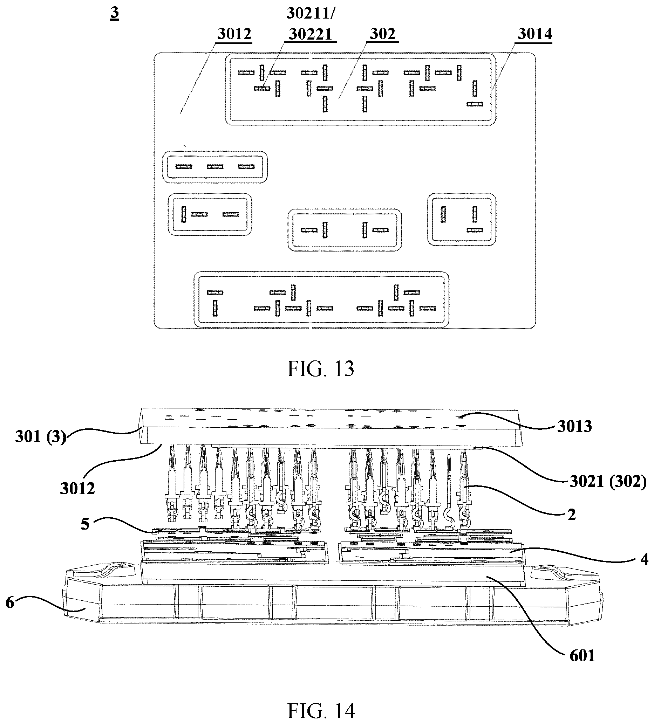

During specific implementation, refer to FIG. 13. FIG. 13 is a schematic diagram of a structure of the side of the second face 3012 of the cover plate 3 according to a possible embodiment of this application. In this embodiment, in the direction from the connection part 30222 to the extension part 30223, the section shape of the third hole 30221 may be but is not limited to the T shape shown in FIG. 11 or the I shape shown in FIG. 12. In addition, the second hole 30211 of the gasket 302 and the first sub-hole 302211 of the third hole 30221 may be obtained through processing in a same process. In this case, the second hole 30211 and the first sub-hole 302211 may be considered as a same hole, so that the processing technic of the gasket 302 is simplified.

When the cover plate 3 provided in any one of the foregoing embodiments of this application is applied to the power module, refer to FIG. 14. FIG. 14 is an exploded view of the power module according to a possible embodiment of this application. In this embodiment, in addition to the cover plate 3 and the pin 2, the power module may further include a substrate 4. The pin 2 may be fixed on a surface of the substrate 4 through bonding or welding, so as to implement an electrical connection between the pin 2 and the substrate 4. In addition, in this application, there may be a specific included angle between the pin 2 and the surface of the substrate 4. For example, the pin 2 may be vertically disposed with the substrate 4, so that the pin 2 is inserted into the corresponding first hole 3013 of the cover plate 3.

The power module may further include a chip 5. The chip 5 and the pin 2 are disposed on a same surface of the substrate 4, and the chip 5 is electrically connected to the substrate 4. In this application, to protect components such as the pin 2 and the chip 5 that are disposed on the substrate 4, after the pin 2 and the chip 5 are fixed on the substrate 4, a plastic packaging material may be disposed on the substrate 4. The plastic packaging material may be but is not limited to an epoxy resin material or the like. In addition, the plastic packaging material covers the chip 5 and an end part that is of the pin 2 and that is used to be connected to the substrate 4. In this application, the second face 3012 of the cover plate 3 may be disposed opposite to the substrate 4. In this way, after the pin 2 is inserted into the corresponding first hole 3013 of the cover plate 3, the plastic packaging material may be pressed by using the cover plate 3, to implement encapsulation protection for the chip 5 and the end part that is of the pin 2 and that is used to be connected to the substrate 4. It should be noted that, in a process of pressing the plastic packaging material, the existing mold 1 shown in FIG. 1 may still be used to apply an acting force to the cover plate 3. This may help improve universality of the mold 1, thereby reducing processing costs of the power module.

Because the gasket 302 is disposed on the second face 3012 of the cover plate 3, when the plastic packaging material is pressed by using the cover plate 3, the body part 3021 of the gasket 302 may abut onto the plastic packaging material, so that the plate body 301 of the cover plate 3 may be prevented from directly exerting an action force on the plastic packaging material. In this way, an acting force exerted by the plate body 301 on the chip 5 may be reduced, to reduce a risk of damage to the chip 5.

Based on this, it may be understood that, by using the power module provided in this application, a plurality of chips 5 may be disposed on the substrate 4 of the power module. In this way, power density of the entire power module can be effectively improved, and a parasitic parameter can be reduced.

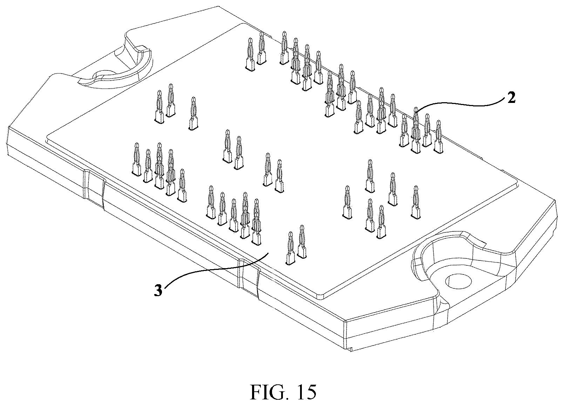

Refer to FIG. 15. FIG. 15 is a schematic diagram of an assembly structure of the power module shown in FIG. 14. In addition to the foregoing structure, the power module provided in this application may further include a molding compound 6. Refer to FIG. 14 and FIG. 15 together. The molding compound 6 has a mounting groove 601. The substrate 4, the chip 5, and the pin 2 shown in FIG. 14 may be mounted in the mounting groove 601, so that the molding compound 6 can protect the substrate 4, the chip 5, and the pin 2. In addition, the cover plate 3 may cover a notch of the mounting groove 601, and the cover plate 3 and the molding compound 6 may be fixed through bonding, threaded connection, or the like, to implement encapsulation of the component accommodated in the mounting groove 601 of the molding compound 6.

In the power module provided in this application, each pin 2 is inserted into one first hole 3013 of the cover plate 3 in a one-to-one correspondence, and the pin 2 is in interference fit with the first hole 3013. Therefore, position precision of the pin 2 of the power module is high, thereby improving reliability of connection between the power module and the system end. In addition, by enabling the pin 2 to perform interference fit with the corresponding first hole 3013, in a process of pressing the plastic packaging material by using the cover plate 3, a risk of overflowing the plastic packaging material from the first hole 3013 may be effectively reduced, thereby avoiding the plastic packaging material from covering a part of the pin 2 for connecting to the system end, to ensure stability of connection between the pin 2 and the system end.

In addition, the body part 3021 of the gasket 302 may play a buffer role between the plate body 301 and the chip 5 of the cover plate 3, thereby reducing the acting force exerted by the plate body 301 on the chip 5, and reducing the risk of damage to the chip 5. In this way, a plurality of chips 5 may be disposed on the substrate 4 of the power module, so that the power density of the entire power module can be effectively improved, and the parasitic parameter can be reduced.

In addition, when the gasket 302 is provided with the limiting part 3022 shown in FIG. 6, the pin 2 may be in interference fit with the third hole 30221 of the limiting part 3022 inserted into the first hole 3013, so that the limiting part 3022 may not only effectively limit the pin 2, but also protect the pin 2, to improve structural reliability of the pin 2.

It should be noted that, in this application, when the gasket 302 and the plate body 301 of the cover plate 3 are separately disposed structures, in a process of assembling the power module, the gasket 302 and the plate body 301 may be first assembled, and then the pin 2 is inserted into the corresponding hole. Alternatively, the pin 2 and the gasket 302 may be assembled first, and then the pin 2 and the gasket 302 that are assembled are mounted on the plate body 301. A mounting sequence is not limited in this application.

The power module provided in the foregoing embodiment of this application may be applied to, but is not limited to, an electronic device such as a servo motor, a frequency converter, or an inverter. The electronic device may include an accommodating cavity. The power module may be accommodated in the accommodating cavity. Because the position degree of the pin of the power module provided in this application is high, the power density of the power module can be effectively improved, and the parasitic parameter can be effectively reduced, performance of the electronic device to which the power module is applied can be improved.

It is clear that a person skilled in the art can make various modifications and variations to this application. This application is intended to cover these modifications and variations of this application

## Claims

1. A power module, comprising a pin (2) and a cover plate (3), wherein the cover plate (3) comprises a plate body (301) and a gasket (302), wherein
the plate body (301) comprises a first face (3011) and a second face (3012) that are disposed back from each other, the plate body (301) is provided with a first hole (3013), and in a direction from the first face (3011) to the second face (3012), the first hole (3013) penetrates through the plate body (301);
the gasket (302) comprises a body part (3021), the body part (3021) is disposed on the second face (3012) of the plate body (301), the body part (3021) is provided with a second hole (30211), and in the direction from the first face (3011) to the second face (3012), the second hole (30211) penetrates through the body part (3021); and
each pin (2) passes through one second hole (30211) and is inserted into one first hole (3013) in a one-to-one correspondence, and each pin (2) is in interference fit with the corresponding first hole (3013),
wherein the second face (3012) of the plate body (301) is provided with a baffle wall (3014), the baffle wall (3014) is of a ring structure, the body part (3021) is disposed in a closed region enclosed by the baffle wall (3014), and a height of the baffle wall (3014) higher than the second face (3012) is greater than or equal to a height of the body part (3021) higher than the second face (3012).

2. The power module according to claim 1, wherein the gasket (302) comprises a limiting part (3022), the limiting part (3022) is disposed on a surface of the body part (3021) that faces the plate body (301), each limiting part (3022) is inserted into one first hole (3013) in a one-to-one correspondence, and the limiting part (3022) is attached to a hole wall of the corresponding first hole (3013); and
the limiting part (3022) has a third hole (30221), and in the direction from the first face (3011) to the second face (3012), the third hole (30221) penetrates through the limiting part (3022); and the pin (2) passes through one second hole (30211) and is inserted into one third hole (30221) in a one-to-one correspondence, and each pin (2) is in interference fit with the corresponding third hole (30221).

3. The power module according to claim 2, wherein a length of the limiting part (3022) inserted into the first hole (3013) is less than or equal to a hole depth of the first hole (3013).

4. The power module according to claim 2 or 3, wherein a wall thickness of the limiting part (3022) is greater than or equal to 0.1 mm and less than or equal to 5 mm.

5. The power module according to any one of claims 2 to 4, wherein the limiting part (3022) comprises a connection part (30222) and an extension part (30223), the connection part (30222) is fixedly connected to the body part (3021), and the extension part (30223) extends from the connection part (30222) in a direction away from the body part (3021); and
the extension part (30223) comprises a first surface (302233) and a second surface (302234) that are disposed back from each other; and in a direction from the extension part (30223) to the connection part (30222), the first surface (302233) tilts in a direction away from the second surface (302234), and/or the second surface (302234) tilts in a direction away from the first surface (302233).

6. The power module according to claim 5, wherein an angle at which the first surface (302233) tilts in the direction away from the second surface (302234) is greater than or equal to 0° and less than or equal to 60°; and/or
an angle at which the second surface (302234) tilts in the direction away from the first surface (302233) is greater than or equal to 0° and less than or equal to 60°.

7. The power module according to claim 5 or 6, wherein a first step surface (3023) is provided between the connection part (30222) and the extension part (30223), the first hole (3013) is a step hole, the step hole has a second step surface such that when the limiting part (3022) is inserted into the first hole (3013), the first step surface (3023) abuts onto the second step surface.

8. The power module according to any one of claims 2 to 7, wherein in a direction from the connection part (30222) to the extension part (30223), a section shape of the third hole (30221) may be a T shape or an I shape.

9. The power module according to any one of claims 2 to 8, wherein in the direction from the connection part (30222) to the extension part (30223), the third hole (30221) comprises a first sub-hole (302211) and a second sub-hole (302212), and the second sub-hole (302212) is a rectangular hole; and
in an aperture direction of the second sub-hole (302212), a length of a section of the rectangular hole is greater than or equal to 0.1 mm and less than or equal to 2 mm; and/or a width of the section of the rectangular hole is greater than or equal to 0.1 mm and less than or equal to 2 mm.

10. The power module according to any one of claims 1 to 9, wherein the height of the body part (3021) higher than the second face (3012) is greater than or equal to 0.1 mm and less than or equal to 10 mm.

11. The power module according to any one of claims 1 to 10, wherein the gasket (302) is an integrally formed structure.

12. The power module according to any one of the claims 1 to 11, wherein the power module comprises a substrate (4) and a chip (5), the chip (5) and the pin (2) are disposed on a same surface of the substrate (4), and the pin (2) and the chip (5) are electrically connected to the substrate (4); and
the substrate (4) is provided with a plastic packaging material, the plastic packaging material covers the chip (5), and the body part (3021) abuts onto the plastic packaging material.

13. An electronic device, comprising an accommodating cavity and the power module according to claim any one of the claims 1 to 12, wherein the power module is accommodated in the accommodating cavity.

## Patentansprüche

1. Leistungsmodul, umfassend einen Stift (2) und eine Abdeckplatte (3), wobei die Abdeckplatte (3) einen Plattenkörper (301) und eine Dichtung (302) umfasst, wobei
der Plattenkörper (301) eine erste Fläche (3011) und eine zweite Fläche (3012) umfasst, die voneinander zurückgesetzt angeordnet sind, der Plattenkörper (301) mit einem ersten Loch (3013) versehen ist und in einer Richtung von der ersten Fläche (3011) zu der zweiten Fläche (3012) das erste Loch (3013) durch den Plattenkörper (301) hindurchdringt;
die Dichtung (302) einen Körperteil (3021) umfasst, der Körperteil (3021) auf der zweiten Fläche (3012) des Plattenkörpers (301) angeordnet ist, der Körperteil (3021) mit einem zweiten Loch (30211) versehen ist und in der Richtung von der ersten Fläche (3011) zu der zweiten Fläche (3012) das zweite Loch (30211) durch den Körperteil (3021) hindurchdringt; und
jeder Stift (2) durch ein zweites Loch (30211) hindurchgeht und in einer Eins-zu-eins-Entsprechung in ein erstes Loch (3013) eingeführt ist und jeder Stift (2) in Presspassung mit dem entsprechenden ersten Loch (3013) steht,
wobei die zweite Fläche (3012) des Plattenkörpers (301) mit einer Prallwand (3014) versehen ist, die Prallwand (3014) eine Ringstruktur aufweist, der Körperteil (3021) in einem geschlossenen Bereich angeordnet ist, der durch die Prallwand (3014) umschlossen ist, und eine Höhe der Prallwand (3014), die höher als die zweite Fläche (3012) ist, größer als oder gleich einer Höhe des Körperteils (3021) ist, die höher als die zweite Fläche (3012) ist.

2. Leistungsmodul nach Anspruch 1, wobei die Dichtung (302) einen Begrenzungsteil (3022) aufweist, der Begrenzungsteil (3022) auf einer Oberfläche des Körperteils (3021) angeordnet ist, die dem Plattenteil (301) zugewandt ist, jeder Begrenzungsteil (3022) in einer Eins-zu-eins-Entsprechung in ein erstes Loch (3013) eingeführt ist und der Begrenzungsteil (3022) an einer Lochwand des entsprechenden ersten Lochs (3013) befestigt ist; und
der Begrenzungsteil (3022) ein drittes Loch (30221) aufweist und in einer Richtung von der ersten Fläche (3011) zu der zweiten Fläche (3012) das dritte Loch (30221) durch den Begrenzungsteil (3022) hindurchdringt; und der Stift (2) durch ein zweites Loch (30211) hindurchgeht und in einer Eins-zu-eins-Entsprechung in ein drittes Loch (30221) eingeführt ist und jeder Stift (2) in Presspassung mit dem entsprechenden dritten Loch (30221) steht.

3. Leistungsmodul nach Anspruch 2, wobei eine Länge des Begrenzungsteils (3022), der in das erste Loch (3013) eingeführt ist, kleiner als oder gleich einer Lochtiefe des ersten Lochs (3013) ist.

4. Leistungsmodul nach Anspruch 2 oder 3, wobei eine Wanddicke des Begrenzungsteils (3022) größer als oder gleich 0,1 mm und kleiner als oder gleich 5 mm ist.

5. Leistungsmodul nach einem der Ansprüche 2 bis 4, wobei der Begrenzungsteil (3022) einen Verbindungsteil (30222) und einen Erstreckungsteil (30223) umfasst, der Verbindungsteil (30222) fest mit dem Körperteil (3021) verbunden ist und sich der Erstreckungsteil (30223) von dem Verbindungsteil (30222) in einer Richtung von dem Körperteil (3021) weg erstreckt; und
der Erstreckungsteil (30223) eine erste Oberfläche (302233) und eine zweite Oberfläche (302234) umfasst, die voneinander zurückgesetzt angeordnet sind; und in einer Richtung von dem Erstreckungsteil (30223) zu dem Verbindungsteil (30222) sich die erste Oberfläche (302233) in eine Richtung von der zweiten Oberfläche (302234) weg neigt und/oder sich die zweite Oberfläche (302234) in eine Richtung von der ersten Oberfläche (302233) weg neigt.

6. Leistungsmodul nach Anspruch 5, wobei ein Winkel, unter dem sich die erste Oberfläche (302233) von der zweiten Oberfläche (302234) weg neigt, größer als oder gleich 0° und kleiner als oder gleich 60° ist; und/oder
ein Winkel, unter dem sich die zweite Oberfläche (302234) von der ersten Oberfläche (302233) weg neigt, größer als oder gleich 0° und kleiner als oder gleich 60° ist.

7. Leistungsmodul nach Anspruch 5 oder 6, wobei eine erste Stufenoberfläche (3023) zwischen dem Verbindungsteil (30222) und dem Erstreckungsteil (30223) bereitgestellt ist, das erste Loch (3013) ein Stufenloch ist, das Stufenloch eine zweite Stufenoberfläche derart aufweist, dass, wenn der Begrenzungsteil (3022) in das erste Stufenloch (3013) eingeführt ist, die erste Stufenoberfläche (3023) an der zweiten Stufenoberfläche anliegt.

8. Leistungsmodul nach einem der Ansprüche 2 bis 7, wobei in einer Richtung von dem Verbindungsteil (30222) zu dem Erstreckungsteil (30223) eine Abschnittsform des dritten Lochs (30221) eine T-Form oder eine I-Form sein kann.

9. Leistungsmodul nach einem der Ansprüche 2 bis 8, wobei in der Richtung von dem Verbindungsteil (30222) zu dem Erstreckungsteil (30223) das dritte Loch (30221) ein erstes Teilloch (302211) und ein zweites Teilloch (302212) umfasst und das zweite Teilloch (302212) ein rechteckiges Loch ist; und
in einer Öffnungsrichtung des zweiten Teillochs (302212) eine Länge eines Abschnitts des rechteckigen Lochs größer als oder gleich 0,1 mm und kleiner als oder gleich 2 mm ist; und/oder eine Breite des Abschnitts des rechteckigen Lochs größer als oder gleich 0,1 mm und kleiner als oder gleich 2 mm.

10. Leistungsmodul nach einem der Ansprüche 1 bis 9, wobei die Höhe des Körperteils (3021), die höher als die zweite Fläche (3012) ist, größer als oder gleich 0,1 mm und kleiner als oder gleich 10 mm ist.

11. Leistungsmodul nach einem der Ansprüche 1 bis 10, wobei die Dichtung (302) eine einstückig gebildete Struktur ist.

12. Leistungsmodul nach einem der Ansprüche 1 bis 11, wobei das Leistungsmodul ein Substrat (4) und einen Chip (5) umfasst, der Chip (5) und der Stift (2) auf einer gleichen Oberfläche des Substrats (4) angeordnet sind und der Stift (2) und der Chip (5) elektrisch mit dem Substrat (4) verbunden sind; und
das Substrat (4) mit einem Kunststoffverpackungsmaterial versehen ist, das Kunststoffverpackungsmaterial den Chip (5) abdeckt und der Körperteil (3021) an dem Kunststoffverpackungsmaterial anliegt.

13. Elektronische Vorrichtung, umfassend einen aufnehmenden Hohlraum und das Leistungsmodul nach einem der Ansprüche 1 bis 12, wobei das Leistungsmodul in dem aufnehmenden Hohlraum aufgenommen ist.

## Revendications

1. Module d'alimentation, comprenant une broche (2) et une plaque de recouvrement (3), dans lequel la plaque de recouvrement (3) comprend un corps de plaque (301) et un joint (302), dans lequel le corps de plaque (301) comprend une première face (3011) et une seconde face (3012) qui sont disposées de manière opposée, le corps de plaque (301) est muni d'un premier trou (3013), et dans une direction de la première face (3011) à la seconde face (3012), le premier trou (3013) traverse le corps de plaque (301) ;
le joint (302) comprend une partie de corps (3021), la partie de corps (3021) est disposée sur la seconde face (3012) du corps de plaque (301), la partie de corps (3021) est munie d'un deuxième trou (30211), et dans la direction de la première face (3011) vers la seconde face (3012), le deuxième trou (30211) traverse la partie de corps (3021) ; et
chaque broche (2) passe à travers un deuxième trou (30211) et est insérée dans un premier trou (3013) en correspondance un à un, et chaque broche (2) est en ajustement serré avec le premier trou (3013) correspondant,
dans lequel la seconde face (3012) du corps de plaque (301) est munie d'une paroi de déflecteur (3014), la paroi de déflecteur (3014) est de structure annulaire, la partie de corps (3021) est disposée dans une zone fermée entourée par la paroi de déflecteur (3014), et une hauteur de la paroi de déflecteur (3014) supérieure à la seconde face (3012) est supérieure ou égale à une hauteur de la partie de corps (3021) supérieure à la seconde face (3012).

2. Module d'alimentation selon la revendication 1, dans lequel le joint (302) comprend une partie de limitation (3022), la partie de limitation (3022) est disposée sur une surface de la partie de corps (3021) faisant face au corps de plaque (301), chaque partie de limitation (3022) est insérée dans un premier trou (3013) en correspondance un à un, et la partie de limitation (3022) est fixée à une paroi de trou du premier trou (3013) correspondant ; et
la partie de limitation (3022) présente un troisième trou (30221), et dans la direction de la première face (3011) à la seconde face (3012), le troisième trou (30221) traverse la partie de limitation (3022) ; et la broche (2) passe à travers un deuxième trou (30211) et est insérée dans un troisième trou (30221) en correspondance un à un, et chaque broche (2) est en ajustement serré avec le troisième trou (30221) correspondant.

3. Module d'alimentation selon la revendication 2, dans lequel une longueur de la partie de limitation (3022) insérée dans le premier trou (3013) est inférieure ou égale à une profondeur de trou du premier trou (3013).

4. Module d'alimentation selon la revendication 2 ou 3, dans lequel une épaisseur de paroi de la partie de limitation (3022) est supérieure ou égale à 0,1 mm et inférieure ou égale à 5 mm.

5. Module d'alimentation selon l'une quelconque des revendications 2 à 4, dans lequel la partie de limitation (3022) comprend une partie de connexion (30222) et une partie de prolongement (30223), la partie de connexion (30222) est fixée à la partie de corps (3021), et la partie de prolongement (30223) se prolonge à partir de la partie de connexion (30222) dans une direction s'éloignant de la partie de corps (3021) ; et
la partie de prolongement (30223) comprend une première surface (302233) et une seconde surface (302234) qui sont disposées de manière opposée ; et dans une direction de la partie de prolongement (30223) vers la partie de connexion (30222), la première surface (302233) s'incline dans une direction s'éloignant de la seconde surface (302234), et/ou la seconde surface (302234) s'incline dans une direction s'éloignant de la première surface (302233).

6. Module d'alimentation selon la revendication 5, dans lequel un angle d'inclinaison de la première surface (302233) dans la direction opposée à la seconde surface (302234) est supérieur ou égal à 0° et inférieur ou égal à 60° ; et/ou
un angle d'inclinaison de la seconde surface (302234) dans la direction opposée à la première surface (302233) est supérieur ou égal à 0° et inférieur ou égal à 60°.

7. Module d'alimentation selon la revendication 5 ou 6, dans lequel une première surface de marche (3023) est prévue entre la partie de connexion (30222) et la partie de prolongement (30223), le premier trou (3013) est un trou de marche, le trou de marche présente une seconde surface de marche de sorte que lorsque la partie de limitation (3022) est insérée dans le premier trou (3013), la première surface de marche (3023) bute contre la seconde surface de marche.

8. Module d'alimentation selon l'une quelconque des revendications 2 à 7, dans lequel, dans une direction allant de la partie de connexion (30222) à la partie de prolongement (30223), une forme de section du troisième trou (30221) peut être en forme de T ou en forme de I.

9. Module d'alimentation selon l'une quelconque des revendications 2 à 8, dans lequel, dans la direction allant de la partie de connexion (30222) à la partie de prolongement (30223), le troisième trou (30221) comprend un premier sous-trou (302211) et un second sous-trou (302212), et le second sous-trou (302212) est un trou rectangulaire ; et
dans une direction d'ouverture du second sous-trou (302212), une longueur d'une section du trou rectangulaire est supérieure ou égale à 0,1 mm et inférieure ou égale à 2 mm ; et/ou une largeur de la section du trou rectangulaire est supérieure ou égale à 0,1 mm et inférieure ou égale à 2 mm.

10. Module d'alimentation selon l'une quelconque des revendications 1 à 9, dans lequel la hauteur de la partie de corps (3021) plus haute que la seconde face (3012) est supérieure ou égale à 0,1 mm et inférieure ou égale à 10 mm.

11. Module d'alimentation selon l'une quelconque des revendications 1 à 10, dans lequel le joint (302) est une structure formée intégralement.

12. Module d'alimentation selon l'une quelconque des revendications 1 à 11, dans lequel le module d'alimentation comprend un substrat (4) et une puce (5), la puce (5) et la broche (2) sont disposées sur une même surface du substrat (4), et la broche (2) et la puce (5) sont connectées électriquement au substrat (4) ; et
le substrat (4) est doté d'un matériau d'emballage en plastique, le matériau d'emballage en plastique recouvre la puce (5), et la partie de corps (3021) bute contre le matériau d'emballage en plastique.

13. Dispositif électronique, comprenant une cavité d'accueil et le module d'alimentation selon l'une quelconque des revendications 1 à 12, dans lequel le module d'alimentation est logé dans la cavité d'accueil.
